# EUROPEAN PATENT APPLICATION

(11) **EP 1 732 115 A1**
(43) Date of publication of application: **13.12.2006**
(21) Application number: 05720930.6
(22) Date of filing: 16.03.2005
(51) Int. Cl.: H01L 21/336, H01L 29/786

(54) **TFT SHEET AND METHOD FOR MANUFACTURING SAME**

(30) Priority: 31.03.2004 JP 2004103245
(71) Applicant: KONICA MINOLTA HOLDINGS, INC., Tokyo 100-0005 (JP)
(72) Inventor: Hirai, K., Konica Minolta Technology Center, Inc., Tokyo 1928505 (JP)
(74) Representative: Rees, Alexander Ellison
(86) International application number: PCT/JP2005/004679
(87) International publication number: WO 2005/098927

(57) **Abstract**

Disclosed is a manufacturing method to effectively form elements with accuracy including a gate electrode, a gate insulating layer, a semiconductor layer, source electrode and a drain electrode used for a thin-film transistor (TFT) sheet on a resin film. The manufacturing method of the TFT sheet, wherein two or more element-forming processes are conducted while rotating a rotating support after a substrate is fixed on the rotating support has been introduced in order to manufacture the TFT sheet in which a plurality of thin-film transistors having a source electrode and a drain electrode connected with a gate electrode, a gate insulating layer and a semiconductor layer on a substrate are connected through a gate busline and a source busline.

## Description

### TECHNICAL FIELD

The present invention relates to a manufacturing method of a thin-film transistor sheet and a thin-film transistor sheet manufactured by the method.

### BACKGROUND

With the spread of information terminals, there are increasing demands for a flat panel display that serves as a display for a computer. Further, with development of the information technology, there has been increased a chance for information offered in a form of a sheet of paper medium in the past to be offered in an electronic form. An electronic paper or a digital paper is demanded increasingly as a display medium for a mobile that is thin, lightweight and handy.

In the case of a display device of a flat sheet type, a display medium is generally formed using an element that employs a liquid crystal, organic EL or electrophoresis method. In the display medium of this kind, a technology for using an active driving element comprised of a thin-film transistor (TFT), serving as an image driving element, is the main current for ensuring uniform image brightness and an image rewriting speed.

The TFT is commonly manufactured by a process comprising forming, on a glass substrate, a semiconductor layer of α-Si (amorphous silicon) or p-Si (poly-silicon) and metal films of source, drain and gate electrodes, in order. In the manufacture of a flat panel display employing such a TFT, a photolithography step with high precision is required in addition to a thin layer forming step requiring a vacuum line carrying out a CVD method or a sputtering method or a high temperature treatment step, which results in great increase of manufacturing cost or running cost. Recent demand for a large-sized display panel further increases those costs described above.

In order to overcome the above-described defects, an organic thin-film transistor employing an organic semiconductor material has been extensively studied (Refer to Patent Document 1 and Non-patent Document 1). Since the organic thin-film transistor can be manufactured at low temperature employing a lightweight substrate difficult to be broken, a flexible display employing a resin film as a substrate can be realized (Refer to Non-patent Document 2). Further, by employing an organic semiconductor material allowing a wet process such as a printing method or a coating method, under atmospheric pressure a display manufacturing process which provides excellent productivity and reduced cost can be realized.

A manufacturing method of an organic TFT using an ink jet method has been proposed, for example, in Patent Documents 2 and 3.
(Patent Document 1) Japanese Patent O.P.I. Publication No. 10-190001
(Patent Document 2) Specification of U.S. Patent No. 6,087,196
(Patent Document 3) WO 01/46987
(Non-patent Document 1) "Advanced Material", 2002, No. 2, p. 99 (review)
(Non-patent Document 2) SID '02 Digest P. 57

### DISCLOSURE OF THE INVENTION

A number of pixel units and a busline corresponding to them, however, can not be formed with accuracy on a sheet by techniques described in the above Patent Documents 2 and 3 since there is present a problem concerning location accuracy of each element of which a TFT is composed. Accordingly, the problem extends fluctuation in performance of TFTs formed on a sheet. When an attempt is made to improve the location accuracy, rising costs is substantially created because an etching rate drops and effective manufacturing can not be achieved. Especially, in the case of using a resin film, those problems occur notably.

The present invention has been made in consideration of the above situation, and it is an object of the present invention to provide a manufacturing method by which all the elements of which a TFT is composed can effectively be formed on a resin film with accuracy.

The above object of the present invention is accomplished by the following structures.
(Structure 1) A manufacturing method of a thin-film transistor (TFT) sheet having elements including a source electrode, a drain electrode, a gate electrode, a gate insulating layer and a semiconductor layer on a substrate possessing the step of conducting two or more element-forming processes while rotating a rotating support, after the substrate is fixed on the rotating support.
(Structure 2) The manufacturing method of the TFT sheet of Structure 1, wherein the two processes or more which are conducted while rotating the rotating support, include any one of formation processes of the source electrode, the drain electrode and the source busline.
(Structure 3) The manufacturing method of the TFT sheet of Structures 1 or 2, wherein the process through which elements are formed while rotating the rotating support includes either an ink jet method or a laser irradiation method
(Structure 4) The manufacturing method of the TFT sheet of any one of Structures 1 - 3, wherein the process through which elements are formed while rotating the rotating support includes a coating process.
(Structure 5) The manufacturing method of the TFT sheet of any one of Structures 1 - 4, wherein the process through which elements are formed while rotating the rotating support includes either a drying process or a heat treatment process.
(Structure 6) The manufacturing method of the TFT sheet of any one of Structures 1 - 5, wherein the process through which elements are formed while rotating the rotating support includes an atmospheric pressure plasma process.
(Structure 7) The manufacturing method of the TFT sheet of Structures 1 - 6, wherein the process through which elements are formed while rotating the rotating support includes a process for forming a light sensitive layer which is exposed before developing.
(Structure 8) The manufacturing method of the TFT sheet of any one of Structures 1 - 7, wherein the process through which the elements are formed while rotating the rotating support includes either a developing process or a washing process.
(Structure 9) The manufacturing method of the TFT sheet of any one of Structures 1 - 8, wherein a rotating condition of the rotating support is changed at least one time in two different processes or more through which elements are formed while rotating the rotating support.
(Structure 10) The manufacturing method of the TFT sheet of any one of Structures 1 - 9, wherein after a substrate, on which at least one element selected from the foregoing elements is formed in advance, is fixed on the rotating support, a location of the element formed is detected, and the different element is formed, based on the location information, at the location of sequence by reading out information of the location and the shape for at least one different element which is additionally formed while rotating the rotating support.
(Structure 11) The TFT sheet manufactured by the method of any one of Structures 1 - 10.

### BRIEF DESCRIPTION OF THE DRAWINGS

Fig. 1 is an arrangement diagram of an example of an additional capacitor type organic TFT.
Fig. 2 is an arrangement diagram of an example of a storage capacitor type organic TFT.
Fig. 3 is a schematic equivalent circuit diagram of an example of a TFT sheet, in which plural TFTs are arranged,
Fig. 4 is a schematic diagram showing a mechanism for detecting the location of elements formed in advance.
Fig. 5 is a schematic diagram showing detection of a gate busline in the case of forming a source busline and a pixel electrode by laser irradiation.
Fig. 6 is a schematic diagram showing a head structure for additionally forming elements.
Fig. 7 is a schematic diagram showing an apparatus structure concerning a manufacturing method of a TFT sheet in the present invention in the case of detecting the location of an element.
Fig. 8 shows a flow chart in which the information of location and shape is output by synchronizing with detection of a busline, and image data is output on time further at a driver of either an ink jet printer or a laser photolithography machine.
Fig. 9 is a schematic diagram showing an example of the method of the present invention of manufacturing a substrate which is fixed on a rotating support
Fig. 10 is a schematic diagram showing an example of the method of the present invention of manufacturing a substrate which is fixed on a rotating support.
Fig. 11 is a schematic diagram showing the apparatus structure employed in Example 1.
Fig. 12 is a schematic diagram showing the electrode pattern of a TFT sheet manufactured in Example 1.
Fig. 13 is a schematic diagram showing the apparatus structure employed in Example 2
Fig. 14 is a schematic diagram showing a TFT formation process in Example 3.
Fig. 15 is a schematic diagram showing the other apparatus structure in the present invention.

### DESCRIPTION OF THE PREFERRED EMBODIMENTS

The present invention will be explained as described below. The present invention, however, is not limited to those described herein.

The manufacturing method of a TFT sheet in the present invention, wherein two processes or more are conducted while rotating the rotating support after a substrate is fixed on a rotating support such as a rotating drum and an endless belt.

The TFT sheet of the present invention in which a plurality of thin-film transistors having a source electrode and a drain electrode connected with a gate electrode, a gate insulating layer and a semiconductor layer on a substrate are connected through a gate busline and a source busline is designed to be formed.

As the thin-film transistor, there are a top gate type thin-film transistor which possesses a source electrode and a drain electrode connected through a semiconductor layer provided on a substrate, a gate insulating layer provided thereon, and a gate electrode provided on the gate insulating layer, and a bottom gate type thin-film transistor which possesses a gate electrode directly on a substrate, a gate insulating layer provided on the substrate, and a source electrode and a drain electrode connected through a semiconductor layer on the gate insulating layer.

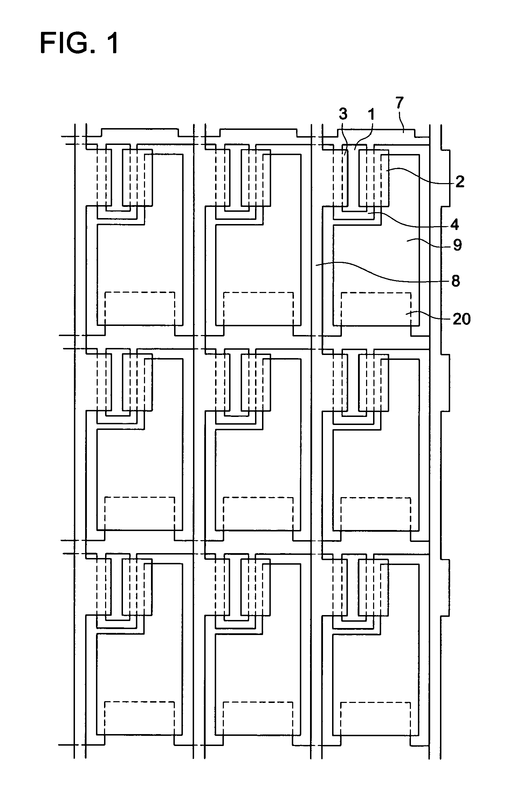

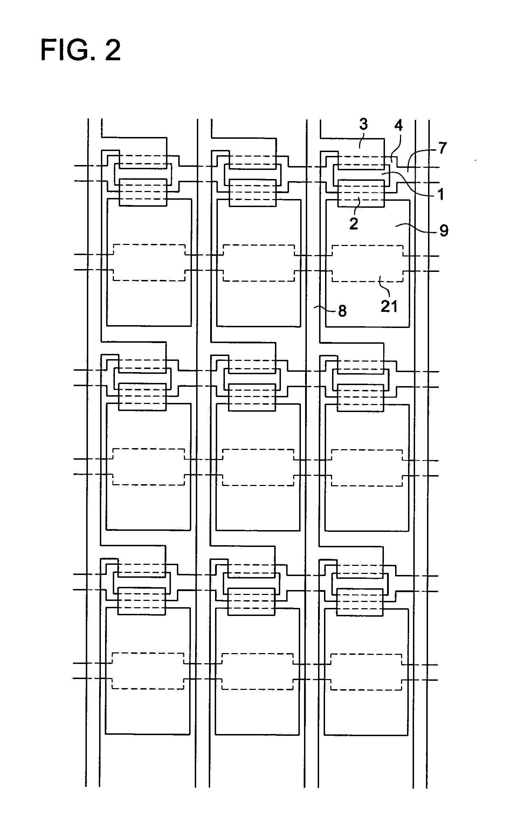

Fig. 1 shows an arrangement example of the bottom gate type organic TFT sheet. The additional capacitor type TFT is a bottom gate type one possessing gate electrode 4 directly on a substrate and possessing source electrode 2 and drain electrode 3 connected with channel made of semiconductor layer 1 through a gate insulating layer, and those elements are connected through gate busline 7 and source busline 8 on a substrate. Numerical number 9 represents a pixel electrode and numerical number 20 an additional capacitor. Fig. 2 shows an arrangement example of the storage capacitor type organic TFT sheet, and numerical number 21 represents a storage capacitor.

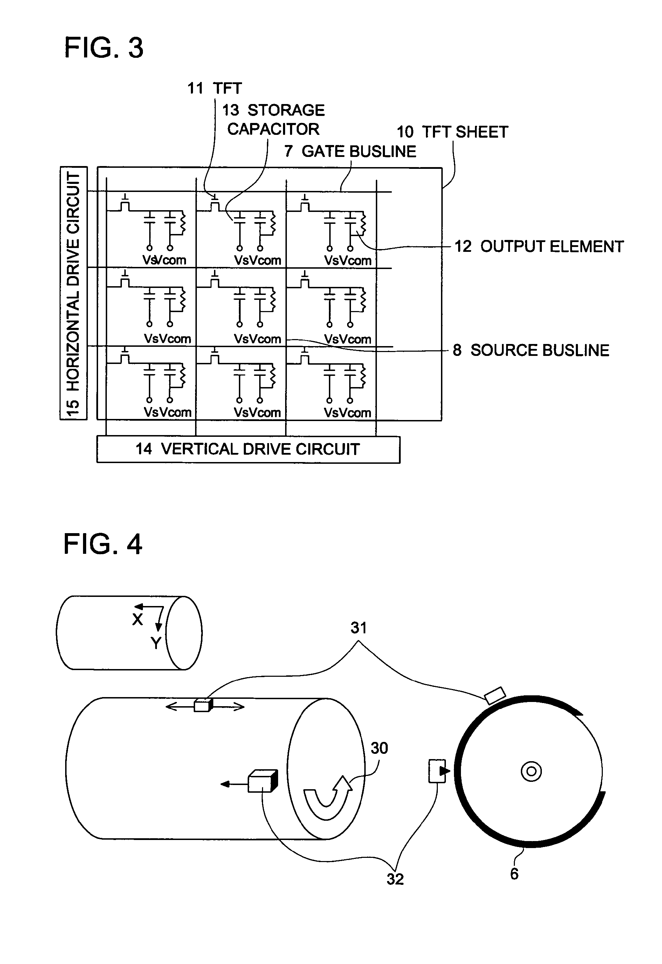

Fig. 3 is a schematic equivalent circuit diagram of an example of the TFT sheet, in which plural TFTs are arranged.

Organic TFT sheet 10 contains many of TFT 11 arranged in a matrix form. Numerical number 7 is a gate busline of the TFT 11, and numerical number 8 a source busline of the TFT 11. Output element 12 is connected to the drain electrode of the TFT 11. The output element 12 is, for example, a liquid crystal or an electrophoresis element, and constitutes pixels in a display. A pixel electrode may be used as an input electrode for an optical sensor. In the figure, liquid crystal as an output element is shown in an equivalent circuit diagram composed of a capacitor and a resistor. Numerical number 13 shows a storage capacitor, numerical number 14 a vertical drive circuit, and numerical number 15 a horizontal drive circuit.

According to the present invention, in order to have effective manufacture, it is preferable that two processes or more which are conducted while rotating the rotating support, include any one of formation processes of a source electrode, a drain electrode and a source busline.

It is preferable that after a substrate on which at least one element is formed in advance is fixed on the rotating support, a location of the element formed is detected and, based on the location information, the different element is formed at the location of sequence by reading out information of the location and the shape for at least one different element which is additionally formed while rotating the rotating support.

As a semiconductor material constituting channel, known ones such as a-Si (amorphous silicone), p-Si (poly-silicone) and an organic semiconductor material are used, and an organic semiconductor material is preferably used. As the organic semiconductor material, π-conjugate materials are used. Examples of the π-conjugate materials include polypyrroles such as polypyrrole, poly(N-substituted pyrrole), poly(3-substituted pyrrole), and poly(3,4-disubstituted pyrrole); polythiophenes such as polythiophene, poly(3-substituted thiophene), poly(3,4-disubstituted thiophene), and polybenzothiophene; polyisothianaphthenes such as polyisothianaphthene; polythienylenevinylenes such as polythienylenevinylene; poly(p-phenylenevinylenes) such as poly(p-phenylenevinylene); polyanilines such as polyaniline, poly(N-substituted aniline), poly(3-substituted aniline), and poly(2,3-substituted aniline); polyacetylnenes such as polyacetylene; polydiacetylens such as polydiacetylene; polyazulenes such as polyazulene; polypyrenes such as polypyrene; polycarbazoles such as polycarbazole and poly(N-substituted carbazole), polyselenophenes such as polyselenophene; polyfurans such as polyfuran and polybenzofuran; poly(p-phenylenes) such as poly(p-phenylene); polyindoles such as polyindole; polypyridazines such as polypyridazine; polyacenes such as naphthacene, pentacene, hexacene, heptacene, dibenzopentacene, tertabenzopentacene, pyrene, dibenzopyrene, chrysene, perylene, coronene, terylene, ovalene, quoterylene, and circumanthracene; derivatives (such as triphenodioxazine, triphenodithiazine, hexacene-6,15-quinone) in which some of carbon atoms of polyacenes are substituted with atoms such as N, S, and O or with a functional group such as a carbonyl group; polymers such as polyvinyl carbazoles, polyphenylene sulfide, and polyvinylene sulfide; and polycyclic condensation products described in Japanese Patent O.P.I. Publication No. 11-195790.

Further, oligomers having repeating units in the same manner as in the above polymers, for example, thiophene hexamers including α-sexithiophene, α, ω-dihexyl-α-sexithiophene, α, ω-dihexyl-α-quiinquethiophene, and α,ω-bis(3-butoxypropyl)-α-sexithiophene, or styrylbenzene derivatives, can be suitably employed.

Further, listed are metallophthalocyanines such as copper phthalocyanine, and fluorine-substituted copper phthalocyanines described in Japanese Patent O.P.I. Publication No. 11-251601; tetracarboxylic acid diimides of condensed ring compounds including naphthalene tetracarboxylic acid imides such as naphthalene 1,4,5,8-teracarboxylic acid diimide, N,N'-bis(4-trifluoromethylbenzyl)naphthalene 1,4,5,8-tretracarboxylic acid diimide, N,N'-bis(1H,1H-perfluoroctyl), N,N'-bis(1H,1H-perfluorobutyl)naphthalene 1,4,5,8-tetracarboxylic acid diimide derivatives, and naphthalene 2,3,6,7-tetracarboxylic acid diimides, and anthracene tetracarbocylic acid diimides such as anthracene 2,3,6,7-tetracarboxylic acid diimides; fullerenes such as C₆₀, C₇₀, C₇₆, C₇₈, and C₈₄; carbon nanotubes such as SWNT; and dyes such as merocyanines and hemicyanines.

Of these n conjugate compounds, preferably employed is at least one selected from the group including oligomers which have thiophene, vinylene, thienylenevinylene, phenylenevinylene, p-phenylene, their substitution product or at least two kinds thereof as a repeating unit and have a repeating unit number n of from 4 to 10, polymers which have the same unit as above and a repeating unit number n of at least 20, condensed polycyclic aromatic compounds such as pentacene, fullerenes, condensed cyclic tetracarboxylic acid diimides of condensed ring compounds, and metallophthalocyanines.

Further, employed as other materials for organic semiconductors may be organic molecular complexes such as a tetrathiafulvalene (TTF)-tetracyanoquinodimethane (TCNQ) complex, a bisethylenetetrathiafulvalene (BEDTTTF)-perchloric acid complex, a BEDTTTF-iodine complex, and a TCNQ-iodine complex. Still further, employed may be σ conjugate polymers such as polysilane and polygermane, as well as organic-inorganic composite materials described in Japanese Patent O.P.I. Publication No. 2000-260999.

In the present invention, the organic semiconductor layer may be subjected to a so-called doping treatment (referred to also as simply doping) by incorporating in the layer, materials working as an acceptor which accepts electrons, for example, acrylic acid, acetamide, materials having a functional group such as a dimethylamino group, a cyano group, a carboxyl group and a nitro group, benzoquinone derivatives, or tetracyanoethylene, tetracyanoquinodimethane or their derivatives, or materials working as a donor which donates electrons, for example, materials having a functional group such as an amino group, a triphenyl group, an alkyl group, a hydroxyl group, an alkoxy group, and a phenyl group: substituted amines such as phenylenediamine: anthracene, benzoanthracene, substituted benzoanthracenes, pyrene, substituted pyrene, carbazole and its derivatives, and tetrathiafulvalene and its derivatives.

The doping herein means that an electron accepting molecule (acceptor) or an electron donating molecule (donor) is incorporated in the layer as a dopant. Accordingly, the layer, which has been subjected to doping, is one which contains the condensed polycyclic aromatic compounds and the dopant. As the dopant in the present invention, a known dopant can be used.

The methods for forming the organic layer include a vacuum deposition method, a molecular beam epitaxial growth method, an ion cluster beam method, a low energy ion beam method, an ion plating method, a CVD method, a sputtering method, a plasma polymerization method, an electrolytic polymerization method, a chemical polymerization method, a spray coating method, a spin coating method, a blade coating method, a dip coating method, a casting method, a roll coating method, a bar coating method, a die coating method, and an LB method. These methods may be used according to kinds of materials used.

Of these, a spin coating method, a blade coating method, a dip coating method, a roll coating method, a bar coating method and a die coating method by which a layer can be formed, using a solution of an organic semiconductor, are preferably used in consideration of the effective manufacture. It is one of the preferred embodiments that an organic semiconductor layer is formed by a coating process while rotating a rotating support. It is preferable that a drying process followed by the foregoing process is also conducted while rotating a rotating support.

When a precursor such as pentacene is soluble in a solvent as disclosed in Advanced Material 1999, Vol. 6, p. 480-483, a precursor layer formed by coating of the precursor solution may be heat treated to form an intended organic material layer. It is preferable that this heat treatment process is also conducted while rotating a rotating support.

Even in the case of forming one element in this manner, it may be necessary to have two processes or more such as a coating process, a heat drying process and so forth applied for, for example, an organic semiconductor layer. In the present invention, however, the specific process is considered to be one process.

The thickness of the organic semiconductor layer is not specifically limited: The thickness of the organic semiconductor layer is ordinarily not more than 1 µm, and preferably from 10 to 300 nm.

In the present invention, materials for forming drain electrode 3, source busline 8, source electrode 2, gate electrode 4, gate busline 7 and pixel electrode 9 are not specifically limited, as long as they are electrically conductive. Examples thereof include platinum, gold, silver, nickel, chromium, copper, iron, tin, antimony, lead, tantalum, indium, palladium, tellurium, rhenium, iridium, aluminum, ruthenium, germanium, molybdenum, tungsten, tin oxide-antimony, indium oxide-tin (ITO), fluorine-doped zinc oxide, zinc, carbon, graphite, glassy carbon, silver paste as well as carbon paste, lithium, beryllium, sodium, magnesium, potassium, calcium, scandium, titanium, manganese, zirconium, gallium, niobium, sodium, sodium-potassium alloy, magnesium, lithium, aluminum, magnesium/copper mixtures, magnesium/silver mixtures, magnesium/aluminum mixtures, magnesium/indium mixtures, aluminum/aluminum oxide mixtures, and lithium/aluminum mixtures. Platinum, gold, silver, copper, aluminum, indium, indium oxide-tin (ITO) and carbon are preferred. Further, known electrically conductive polymers whose electrical conductivity is improved by doping are preferably used. Examples thereof include electrically conductive polyaniline, electrically conductive polypyrrole, electrically conductive polythiophene, and complex of electrically conductive polyethylenedioxythiophene and polystyrene sulfonic acid. Of these, ones, which provide a low electric resistance at an interface with the semiconductor layer, are preferred.

As a method for forming the electrode, there are a method in which the electrode is formed according to a known photolithography or lift-off method from an electrically conductive layer of the conductive material described above formed according to a vacuum deposition method or a sputtering method, a method in which the electrode is formed according to thermal transfer of the conductive material to a foil of a metal such as aluminum or copper, and a method in which the electrode is formed by etching a resist of the conductive material formed by an ink jet method. The electrode may be formed by ejecting in the form of electrode a solution or dispersion liquid of an electrically conductive polymer or a dispersion liquid of electrically conductive particles onto the surface on which the electrode is to be directly formed by the ink jet method or by subjecting to photolithography or laser ablation the coated layer of the solution or the dispersion liquid. Further, employing ink or conductive paste containing an electrically conductive polymer or electrically conductive particles, the electrode may be formed by printing in the electrode pattern onto the surface on which the electrode is to be formed according to a printing method such as letterpress printing, intaglio printing, planographic printing or screen printing.

Methods for preparing such a metal particle dispersion include a physical preparation method such as a gas vaporization method, a sputtering method, or a metallic vapor preparation method and a chemical preparation method such as a colloid method or a co-precipitation method in which metal ions are reduced in a liquid phase to produce metal particles. The metal particles dispersion are preferably ones prepared according to a colloid method disclosed in Japanese Patent O.P.I. Publication Nos. 11-76800, 11-80647, 11-319538, and 2000-239853, or ones prepared according to a gas vaporization method disclosed in Japanese Patent O.P.I. Publication Nos. 2001-254185, 2001-53028, 2001-35255, 2000-124157 and 2000-123634. After a layer is formed from these metal particle dispersions by a method as follows, a solvent is dried, and the metal particles are heat-fused to form an electrode by being subjected to heat treatment at a temperature of from 100 to 300 °C, and preferably at a temperature of from 150 to 200 °C.

A method of permeating the insulation layer capable of receiving the fluid electrode material in the electrode or busline pattern is used.

It is preferable that an insulation layer capable of receiving a fluid electrode material is a porous layer containing inorganic particles and a small amount of hydrophilic polymer.

Examples of the inorganic particles include, for example, precipitated calcium carbonate, heavy calcium carbonate, magnesium carbonate, kaolin, clay, talc, calcium sulfate, barium sulfate, titanium dioxide, zinc oxide, zinc hydroxide, zinc sulfide, zinc carbonate, hydrotalcite, aluminum silicate, diatomaceous earth, calcium silicate, magnesium silicate, synthetic non-crystalline silica, colloidal silica, alumina, colloidal alumina, false boehmite, aluminum hydroxide, lithopone, zeolite, magnesium hydroxide, and the like.

Examples of the hydrophilic polymer include, for example, gelatin (for example, alkali treated gelatin, acid treated gelatin and a derivative gelatin in which amino group is blocked up by phenyl isocyanate or phthalic anhydride), polyvinyl alcohol (an average polymerization degree of preferably 300 to 4000 and a saponification degree of preferably 80 to 99.5%), polyvinyl pyrrolidone, polyethylene oxide, hydroxyl ethyl cellulose, polyacrylamide, agar, pullulan, dextran, acrylic acid, carboxymethyl cellulose, casein, and alginic acid. Two kinds or more of hydrophilic polymer can be used at the same time.

In the manufacturing method of the present invention, it is preferable that either an ink jet method or a laser irradiation method is used from the aspect of controlling the location and the shape with ease, when source busline 8, source electrode 2, drain electrode 3, gate electrode 4, gate busline 7, and a pixel electrode are formed as elements.

Fig. 4 is a schematic diagram showing a mechanism for detecting the location of elements formed in advance.

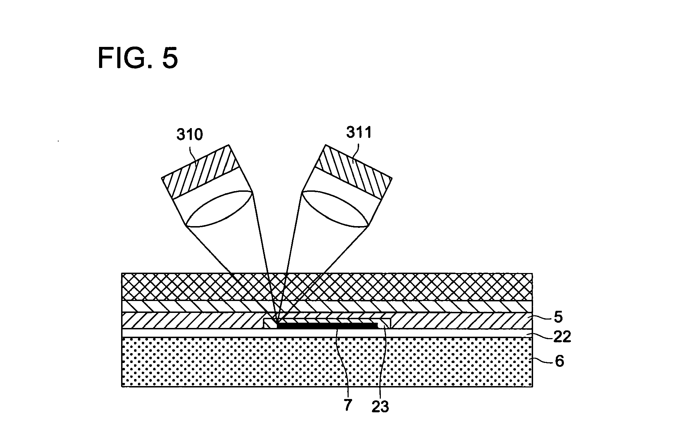

Location detection sensor 31 precedes element formation means 32 such as an ink jet printer and a laser photolithography machine located at the downstream side in the direction of conveyance Y (the direction of drum rotation) for substrate 6, to move in the direction X in the drawing, adjoining drum 30, and the location of the element formed in advance on substrate 6 which is fixed on the drum is detected. The elements on the entire substrate may be detected, or the elements may partially be detected by sampling. A plurality of location detection sensors may be installed, or a linearly-arranged head with a plurality of the detection sensors may be installed. It is preferable that reflection of the electrode or the busline is detected by using an optical sensor combining light emitter 310 and photo detector 311 as shown in Fig. 5 (described later), and the detection sensors may be embedded in rotating drum 30.

Any method in which the edge of a substrate is held down by a clamping mechanism or suction is employed in order to fix the substrate.

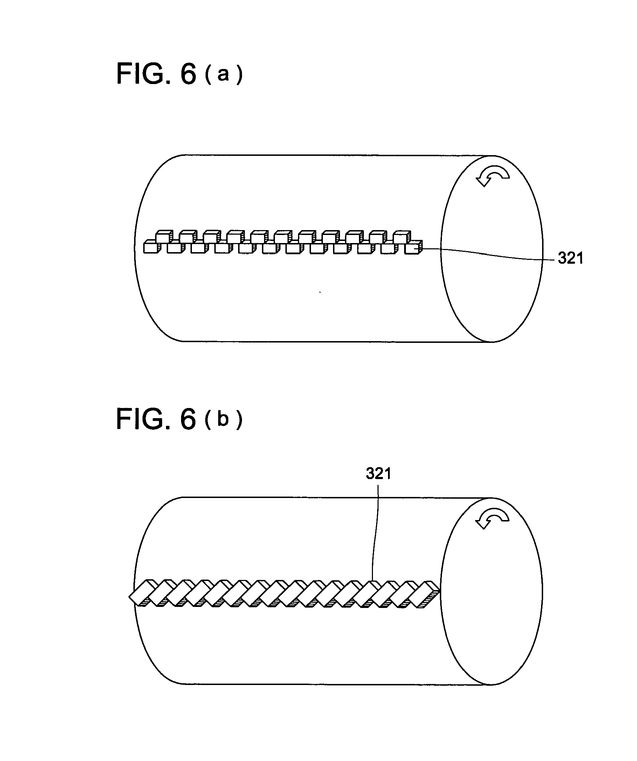

In addition, it is preferable to use a multi-nozzle head for an ink jet printer and a multi-beam head for a laser photolithography machine as element formation means 32. When those heads 321 are connected and are arranged inline as shown in Fig. 6(a), etching time is reduced, and output location accuracy is also improved. Output resolution can further be improved by tilting heads as shown in Fig. 6(b).

An ablation layer is used for forming an electrode by laser irradiation.

As the energy light absorbing agent, there are various organic or inorganic materials capable of absorbing energy light. For example, when infrared laser is used as a laser source, pigment absorbing infrared light, dyes, metals, metal oxides, metal nitrides, metal carbonates, metal borides, graphite, carbon black, titanium black, and ferromagnetic metal powder such as metal magnetic powder containing Al, Fe, Ni, or Co as a main component can be used. Among these, carbon black, dyes such as cyanine dyes and Fe containing ferromagnetic metal powder are preferred. The content of the energy light absorbing agent of the ablation layer is from 30 to 95% by weight, and preferably from 40 to 80% by weight.

The binder resin used in the ablation layer may be any resin as long as it can carry the colorant particle described above. Examples of the binder resin include a polyurethane resin, a polyester resin, a vinyl chloride resin, a polyvinyl acetal resin, a cellulose resin, an acryl resin, a phenoxy resin, a polycarbonate resin, a polyamide resin, a phenol resin, and an epoxy resin. The content of the binder resin in the ablation layer is from 5 to 70% by weight, and preferably from 20 to 60% by weight.

The ablation layer refers to a layer to be ablated by irradiation of a high density energy light. Herein, "ablated" refers to phenomenon in which an ablation layer is completely scattered or a part of the layer is destroyed and/or scattered by its physical or chemical change, or the physical or chemical change occurs only near the interface between the layer and its adjacent layer. A resist can be formed employing this phenomenon, and then electrodes can be formed.

The high density energy light can be used without any special limitation as long as it is light capable of ablating an ablation layer on exposure. As an exposure method, flash exposure may be carried out through a photomask employing a xenon lamp, a halogen lamp or a mercury lamp, or scanning exposure may be carried out employing a convergent laser light. Infrared laser, particularly a semiconductor laser having an output power of from 20 to 200 mW per one beam is preferably used. The energy density used is preferably from 50 to 500 mJ/cm², and more preferably from 100 to 300 mJ/cm².

According to a manufacturing method of a TFT sheet in the present invention, an electrode material-repellent layer having a repelling property to the electrode on a light sensitive layer prepared in advance is formed, an etching process of the electrode material-repellent layer is conducted after exposure and development of the foregoing light sensitive layer, and it is preferable to form an electrode pattern after the electrode is supplied to the electrode material-repellent layer which has been etched. More specifically, a fluid electrode material adheres to area where the etched electrode material-repellent layer has been removed by supplying the fluid electrode material to the area, and the electrode is prepared to form the electrode pattern.

The electrode material-repellent layer is a layer having a repelling property to the electrode material as well as a layer in which an etching process can be conducted after exposure and development of the light sensitive layer. A so-called waterless planographic printing plate ink-repellent layer and so forth which can be used as those electrode material-repellent layers described in Japanese Patent O.P.I. Publication No. 9-292703, Japanese Patent O.P.I. Publication No. 9-319075, Japanese Patent O.P.I. Publication No. 10-244773, Japanese Patent Examined Publication No. 54-26923, Japanese Patent Examined Publication No. 56-23150, Japanese Patent Examined Publication No. 61-614, Japanese Patent O.P.I. Publication No. 8-82921, Japanese Patent O.P.I. Publication No. 10-319579, Japanese Patent O.P.I. Publication No. 2000-275824, Japanese Patent O.P.I. Publication No. 2000-330268, Japanese Patent O.P.I. Publication No. 2001-201849, Japanese Patent O.P.I. Publication No. 2001-249445, Japanese Patent O.P.I. Publication No. 2001-324800, Japanese Patent O.P.I. Publication No. 2002-229189, Japanese Patent O.P.I. Publication No. 4-324865, Japanese Patent O.P.I. Publication No. 5-53318, Japanese Patent O.P.I. Publication No. 5-257269, Japanese Patent O.P.I. Publication No. 6-89023, Japanese Patent O.P.I. Publication No. 7-199454, Japanese Patent O.P.I. Publication No. 8-328240, Japanese Patent O.P.I. Publication No. 9-62001, Japanese Patent O.P.I. Publication No. 9-120157, Japanese Patent O.P.I. Publication No. 11-30852, Japanese Patent O.P.I. Publication No. 2001-188339, Japanese Patent O.P.I. Publication No. 2001-343741, Japanese Patent O.P.I. Publication No. 2002-131894 and Japanese Patent O.P.I. Publication No. 2002-268216. It is preferable to use a silicone rubber layer from the aspect of obtaining the improved resolution and eliminating the leakage current between electrodes.

The silicone rubber layer usable may be optionally selected from known ones such as those disclosed in Japanese Patent O.P.I. Publication No. 7-164773. Two cross-linking type silicone rubber layers, disclosed in Japanese Patent O.P.I. Publication No. 10-244773, such as a condensation cross-linking type silicone rubber layer in which a condensation cross-linking type silicone rubber layer composition is hardened by a condensation reaction and an addition cross-linking type silicone rubber layer in which an addition cross-linking type silicone rubber layer composition is hardened by an addition reaction, are preferably used.

The silicone rubber layer composition is dissolved in a suitable solvent, and the resulting solution is used.

The thickness of an electrode material-repellent layer is preferably from 0.05 to 10 µm, and more preferably from 0.1 to 2 µm.

The method for etching a light sensitive layer and an electrode material-repellent layer may be any method as long as the electrode material-repellent layer can be etched by conducting exposure and development to the light sensitive layer. For example, a light sensitive layer used in an etching process of the waterless planographic printing plate technique can be employed. The light sensitive layer is preferably an ablation layer.

Fig. 5 shows schematically the detection in the case of forming a source busline and a pixel electrode by laser irradiation, while rotating a rotating support after gate busline 7 is detected. Gate busline 7 formed on substrate 6 having subbing layer 22, has anodized oxidization film 23 and is covered with gate insulating layer 5, and the location of a gate busline is detected in the situation that an ablation layer and a layer in which metal particles of an electrode material are dispersed are formed on the gate insulating layer.

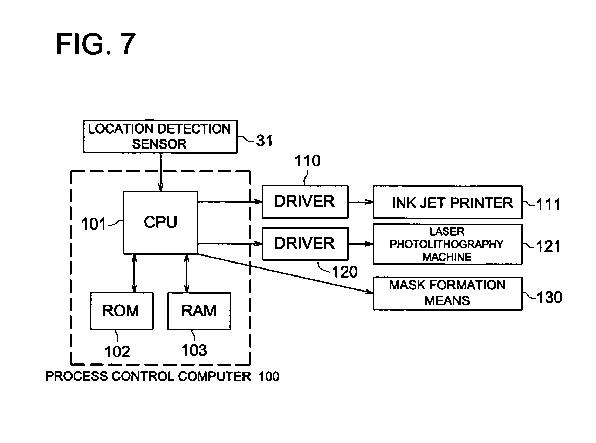

Fig. 7 shows an example of the apparatus framework concerning the manufacturing method of a TFT sheet in the present invention for the case of detecting the location of an element.
As an example of the embodiment, a substrate on which a gate busline is formed is conveyed by rotating a rotating support, and the location information is output to the central processing unit (CPU) 101 in TFT sheet manufacturing process control computer 100 after location detection sensor 31 detects the location of gate busline g1, g2, - - - , gN. Computer 100 possesses a processing program in ROM 102 as a memory in advance in order to read out the location , the shape and data of the arrangement of elements in a TFT corresponding to a production lot, and on the basis of the busline location information which is output from location detection sensor 31, a processing program is read out from ROM 102. Referring to data of the arrangement in ROM 102, data of the location and the shape is written in RAM 103 in corresponding to the production lot by processing the existing arrangement of each of TFT elements formed on a TFT sheet.

For example, even though some variations are shown in each interval of gate busline g1, g2, - - - , gN, which is due to elasticity of a resin sheet and a manufacturing method of a busline, and some fluctuations occur in the lines, all the TFTs are reliably connected through the gate busline and the source busline, since data of the other location and shape of elements are produced on the basis of detecting the busline location.

In the case of forming elements for the output information of location and shape by an ink jet method or a laser irradiation method, CPU 101 reads out the location and the shape corresponding to a production lot from RAM 103, and elements are formed while rotating the rotating support by outputting image data at driver 110 of ink jet printer 111 or driver 120 of laser photolithography machine 121 through an interface (I/F) which is not illustrated.

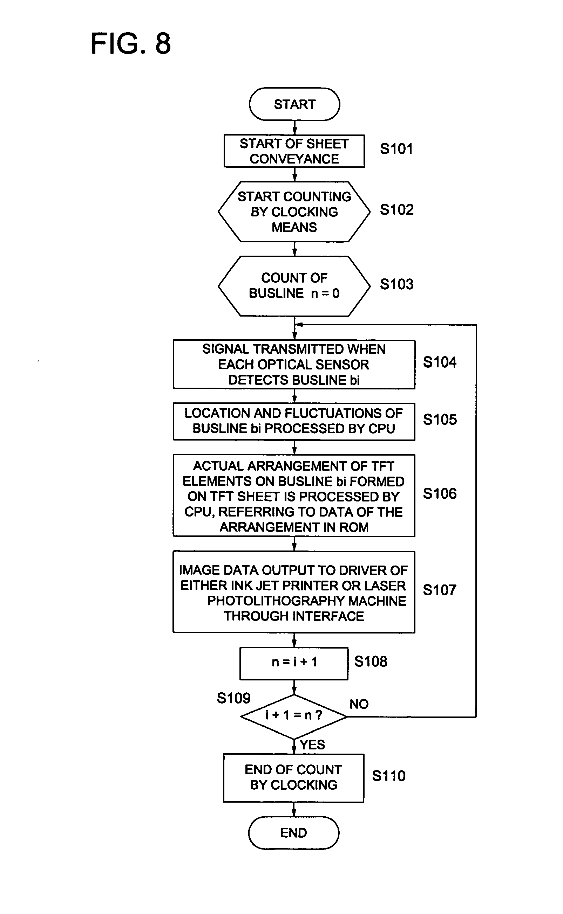

A flow chart, in this case, in which the information of location and shape is output by synchronizing with detection of a busline, and image data is output on time further at a driver of either the ink jet printer or the laser photolithography machine is shown in Fig. 8. In this case, the information of location and shape is not necessarily stored in RAM 103. Though this example indicates that the information of location and shape is output at the same time as detecting, it may be allowed to output after some buslines are detected, and it may also be allowed to start to output through the information with the location of elements on the busline further than that after some buslines.

The conveyance of a sheet on which a busline is formed by rotation of rotating drum 30 is started (Step S101), and a clocking means owned by CPU 101 starts counting (Step S102). CPU 101 also resets count of the busline n=i to 0 (Step S103).

Location detection sensor 31 has a plurality of optical sensors s1, s2, - - - , sn, and the signal is transmitted to CPU101 when each of optical sensors detects busline bi (Step S104). After making the clock count and the signal transmitted from an optical sensor to correspond each other, CPU 101 processes the location and fluctuations of busline bi as image data which are plotted, for example, on an X-Y coordinate (Step S105). CPU 101 processes the actual arrangement of TFT elements on busline bi formed on a TFT sheet, referring to data of the arrangement in ROM 102 (Step S106). Image data is output to a driver of either an ink jet printer or a laser photolithography machine through an interface (Step S107).

Next, after CPU 101 sets count of the busline n to i + 1 (Step S108) and checks if all the buslines have been detected (i + 1 = N?) completely (Step S109), repetition from Step S104 to Step S109 is made until detection of all the buslines has been completed.

When detection of all the buslines is completed, the count by clocking ends (Step S110) to complete processing.

In the present invention, it is also preferable that source electrode 2 and drain electrode 3 are formed by using a photolithography technique, and in this case, a light sensitive resin solution is coated on the entire surface of an organic semiconductor layer through a protective layer to form a light sensitive resin layer.

Though positive type and negative type known materials can be used as a light sensitive resin layer, it is preferable to use a laser sensitive material available for laser exposure. As such a laser sensitive resin material, dye sensitization type photopolymerization photosensitive materials described in (1), infrared laser light sensitive negative type photosensitive materials described in (2) and infrared laser light sensitive and positive type photosensitive materials described in (3) are provided as follows.
(1) Japanese Patent O.P.I. Publication No. 11-271969, Japanese Patent O.P.I. Publication No. 2001-117219, Japanese Patent O.P.I. Publication No. 11-311859 and Japanese Patent O.P.I. Publication No. 11-352691.
(2) Japanese Patent O.P.I. Publication No. 9-179292, U.S. Patent No. 5,340,699, Japanese Patent O.P.I. Publication No. 10-90885, Japanese Patent O.P.I. Publication No. 2000-321780 and Japanese Patent O.P.I. Publication No. 2001-154374.
(3) Japanese Patent O.P.I. Publication No. 9-171254, Japanese Patent O.P.I. Publication No.5-115144, Japanese Patent O.P.I. Publication No. 10-87733, Japanese Patent O.P.I. Publication No. 9-43847, Japanese Patent O.P.I. Publication No. 10-268512, Japanese Patent O.P.I. Publication No. 11-194504, Japanese Patent O.P.I. Publication No. 11-223936, Japanese Patent O.P.I. Publication No. 11-84657, Japanese Patent O.P.I. Publication No. 11-174681, Japanese Patent O.P.I. Publication No. 7-285275, Japanese Patent O.P.I. Publication No. 2000-56452, WO 97/39894 and WO 98/42507. Infrared laser light sensitive negative type photosensitive materials (2) and infrared laser light sensitive positive type photosensitive materials (3) are preferable, considering that a process is not limited only in a dark place.

In the photolithography technique, subsequently by etching a process conducted by using a dispersion substance of metal particles or an electrically conductive polymer as a source electrode material and a drain electrode material and by heat-fusing as needed, the source electrode or the drain electrode can easily be prepared with high accuracy, etching processes in various forms can easily be conducted, and an organic TFT can easily be manufactured.

Solvents for preparing a coating liquid of the light sensitive resin layer include propylene glycol monomethyl ether, propylene glycol monoethyl ether, methyl cellosolve, methyl cellosolve acetate, ethyl cellosolve, ethyl cellosolve acetate, dimethylformamide, dimethylsulfoxide, dioxane, acetone, cyclohexanone, trichloroethylene, and methyl ethyl ketone. These solvents may be used singly or as a mixture of two or more kinds thereof.

Coating methods such as a spray coating method, a spin coating method, a blade coating method, a dip coating method, a casting method, a roll coating method, a bar coating method and a die coating method are used as a method for forming a light sensitive resin layer.

From the aspect of suppressing the light reaching an organic semiconductor layer in order to avoid deterioration of the organic semiconductor layer caused by light, light transmittance of the light sensitive resin layer may be reduced by containing colorants such as dyes and an ultraviolet ray absorbing agent.

As a light source for the imagewise exposure of the light sensitive layer, laser is preferred, and examples of the laser include an argon laser, a semiconductor laser, a He-Ne laser, a YAG laser, and a carbon dioxide gas laser, and a semiconductor laser, which has an emission wavelength at the infrared wavelength regions, is preferred. The output power of the laser is suitably not less than 50 mW, and preferably not less than 100 mW, which forms an image with high accuracy.

Next, the light sensitive resin layer is developed. A water-based alkali developer is suitable as a developer used for developing the light sensitive resin. For example, an aqueous solution of alkali metal salt such as sodium hydrate, potassium hydrate, sodium carbonate, potassium carbonate, sodium metasilicate, potassium metasilicate, dibasic sodium phosphate or tribasic sodium phosphate, and an aqueous solution of alkali compound such as ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, choline, pyrole, piperidine, 1,8-diazabicyclo-[5,4,0]-7-undecene or 1,5-diazabicyclo-[4,3,0]-5-nonane can be provided as a water-based alkali developer. In the present invention, an alkali compound concentration in the alkali developer is from 1 to 10% by weight, and preferably from 2 to 5% by weight.

Organic solvents such as anionic surfactant, ampholytic surfactant and alcohol can be added into the developer as needed. Organic solvents usefully used include propylene glycol, ethylene glycol monophenylether, benzylalcohol and n-propylalcohol.

A process in which a light sensitive resin layer is removed can be added as needed. In the case of removing the light sensitive resin layer after etching a layer of a dispersion substance of metal particles or an electrically conductive polymer, a positive type material is preferably used as a light sensitive resin material. It is preferable to mix phenol resin such as novolac resin and polyvinylphenol as a composite to form a light sensitive resin layer. Examples as novolac resin include phenol-formaldehyde resin, cresol·formaldehyde resin, phenol·cresol·formaldehyde copolycondensation resin described in Japanese Patent O.P.I. Publication No. 55-57841, and p-substituted phenol·phenol or cresol·formaldehyde copolycondensation resin described in Japanese Patent O.P.I. Publication No. 55-127553. In the case of removing the light sensitive resin layer after etching a layer of a dispersion substance of metal particles or an electrically conductive polymer, an organic solvent such as an alcohol type solvent, an ether type solvent, an ester type solvent, a ketone type solvent or a glycol ether type solvent is optionally selected to remove the light sensitive resin layer. It is preferable to use an ether type solvent or a ketone type solvent for preventing a decline in electrical conductivity and for increasing a residual ratio of the electrically conductive polymer layer. Tetrahydrofuran (THF) which is an ether type of solvent is most preferably used.

In addition, material which does not affect an organic semiconductor layer is used for a protective layer in a manufacturing process of an organic TFT or after manufacturing the organic TFT, and material which is not affected by the coating process is used in the case of forming a photosensitive composite of a light sensitive resin layer on a protective layer. In consideration of the influence on the organic semiconductor layer, the material can be selected from an acrylic polymer or copolymer like polymethylmethacrylate (PMMA) and a known polymer such as an urethane resin, a polyester resin or a polyolefin resin. It is further preferable that material which is not affected by the etching process of a light sensitive resin layer is used. Such material preferably contains a hydrophilic polymer and more preferably is an aqueous solution or an aqueous dispersion of the hydrophilic polymer. The hydrophilic polymer hereinafter referred to is a polymer soluble or dispersible in water, an aqueous acidic, an alkali aqueous solution or an alcohol aqueous solution, or an aqueous solution of various surfactants. Examples of the hydrophilic polymer include a homopolymer or copolymer made of a component such as polyvinyl alcohol, methacrylic acid 2-hydroxyethyl (HEMA), acrylic acid, or acryl amide. It is preferable that such an aqueous solution or an aqueous dispersion of the hydrophilic polymer is coated to form an organic semiconductor protective layer.

As another example thereof, material containing inorganic oxides or inorganic nitrides is also preferred, since the material has no influence on the organic semiconductor, and it is not affected in the coating process of another layer. Further, a material to be used in a gate insulating layer described later can also be used. The organic semiconductor protective layer containing inorganic oxides or inorganic nitrides is preferably formed according to an atmospheric pressure plasma method.

Thickness of the organic semiconductor protective layer is preferably 0.01 µm to 10 µm.

It is preferable that such a developing process or a washing process is also conducted while rotating a rotating support.

Various insulating films may be employed as the gate insulating layer. The insulating layer is preferably an inorganic oxide film comprised of an inorganic oxide with high dielectric constant. Examples of the inorganic oxide include silicon oxide, aluminum oxide, tantalum oxide, titanium oxide, tin oxide, vanadium oxide, barium strontium titanate, barium zirconate titanate, zirconic acid lead carbonate, lead lanthanum titanate, strontium titanate, barium titanate, barium magnesium fluoride, bismuth titanate, strontium bismuth titanate, strontium bismuth tantalate, bismuth niobate tantalate, and yttrium trioxide. Of these, silicon oxide, silicon nitride, aluminum oxide, tantalum oxide or titanium oxide is particularly preferred. An inorganic nitride such as silicon nitride or aluminum nitride can be also suitably used.

The methods for forming the above film include a dry process such as a vacuum deposition method, a molecular beam epitaxial growth method, an ion cluster beam method, a low energy ion beam method, an ion plating method, a CVD method, a sputtering method, or an atmospheric pressure plasma method, a wet process such as a spray coating method, a spin coating method, a blade coating method, a dip coating method, a casting method, a roll coating method, a bar coating method, or a die coating method, and a patterning method such as a printing method or an ink-jet method. These methods can be used, depending on kinds of materials used in the insulating layer.

As the typical wet process, there can be used a method of coating a dispersion liquid obtained by dispersing inorganic oxide particles in an organic solvent or water optionally in the presence of a dispersant such as a surfactant and drying, or a so-called sol gel method of coating a solution of an oxide precursor such as an alkoxide and drying.

Among the above, the preferred is an atmospheric pressure plasma method. It is preferable in the present invention that the atmospheric pressure plasma process is conducted while rotating a rotating support.

How to form an insulating film by atmospheric pressure plasma treatment is a process for forming a thin film on a substrate by generating discharge at atmospheric pressure or at approximately atmospheric pressure and by plasma-exciting a reactive gas, and its method (hereinafter referred to also as an atmospheric pressure plasma method) is described in Japanese Patent O.P.I. Publication Nos. 11-61406, 11-133205, 2000-121804, 2000-147209, and 2000-185362. This method can form a thin film having high performance at high productivity.

It is preferred that the gate insulating layer is comprised of an anodization film or an anodization film and an insulating film. The anodization film is preferably subjected to sealing treatment. The anodization film is formed on a metal capable of being anodized by anodizing the metal according to a known method.

Examples of the metal capable of being anodized include aluminum and tantalum. An anodization treatment method is not specifically limited and the known anodization treatment method can be used. Anodization treatment forms an oxidization film. An electrolytic solution used in the anodization treatment may be any as long as it can form a porous oxidation film. Examples of electrolytes in the electrolytic solution include sulfuric acid, phosphoric acid, oxalic acid, chromic acid, boric acid, sulfamic acid, benzene sulfonic acid or their salt, and a mixture thereof. Anodization treatment conditions cannot be specified since they vary depending on kinds of an electrolytic solution used. Generally, the concentration of the electrolytic solution is from 1 to 80% by weight, the temperature of the electrolytic solution is from 5 to 70 °C, electric current density is from 0.5 to 60 A/dm², voltage applied is from 1 to 100 V, and electrolytic time is from 10 seconds to 5 minutes. It is preferred that an aqueous solution of sulfuric acid, phosphoric acid or boric acid is used as an electrolytic solution, and direct current is used. Alternating current can be also used. The concentration of the above acid of the electrolytic solution is preferably from 5 to 45% by weight. Anodization treatment is preferably carried out in the electrolytic solution at an electric current density of from 0.5 to 20 A/dm² at a temperature of from 20 to 50 °C for 20 to 250 seconds.

As the gate insulating layer, an organic compound film can be also used. Examples of the organic compound used in the organic compound film include polyimide, polyamide, polyester, polyacrylate, a photo-curable resin such as a photo-radical polymerizable or photo-cation polymerizable resin, a copolymer containing an acrylonitrile unit, polyvinyl phenol, polyvinyl alcohol, novolak resin, and cyanoethylpullulan.

As a method of forming the organic compound film, the wet process described above is preferably used.

The inorganic oxide film and the organic oxide film can be used in combination and laminated. The thickness of the insulating film above is generally from 50 nm to 3 µm, and preferably from 100 nm to 1 µm.

An orientation layer may be provided between the gate insulating layer and the semiconductor layer. As the orientation layer, a self organization layer is preferably used which is formed from a silane coupling agent such as octadecyltrichlorosilane or trichloromethylsilane, alkane phosphoric acid, alkane sulfonic acid, or an alkane carboxylic acid.

In the present invention, the substrate is a resin sheet comprised of a resin. Examples of the resin sheet include resin sheets comprised of, for example, polyethylene terephthalate (PET), polyethylene naphthalate (PEN), polyethersulfone (PES), polyetherimide, polyether ether ketone, polyphenylene sulfide, polyallylate, polyimide, polycarbonate (PC), cellulose triacetate (TAC), or cellulose acetate propionate (CAP). Use of such a resin sheet makes it possible to decrease weight, to enhance portability, and to enhance durability against impact due to its flexibility, as compared to glass.

As described above, it is preferred that a change of the rotation condition of a rotating support is taken into account, since various different types of processes which are two processes or more for forming elements while rotating a rotating support, such as an ink jet process, a laser irradiation process, a coating process, a drying process, a heat treatment process, an atmospheric pressure plasma process, a developing process, a washing process and an element location detection process are combined, and time consumed for each of processes varies as time for processes sequentially conducted elapses while rotating a rotating support.

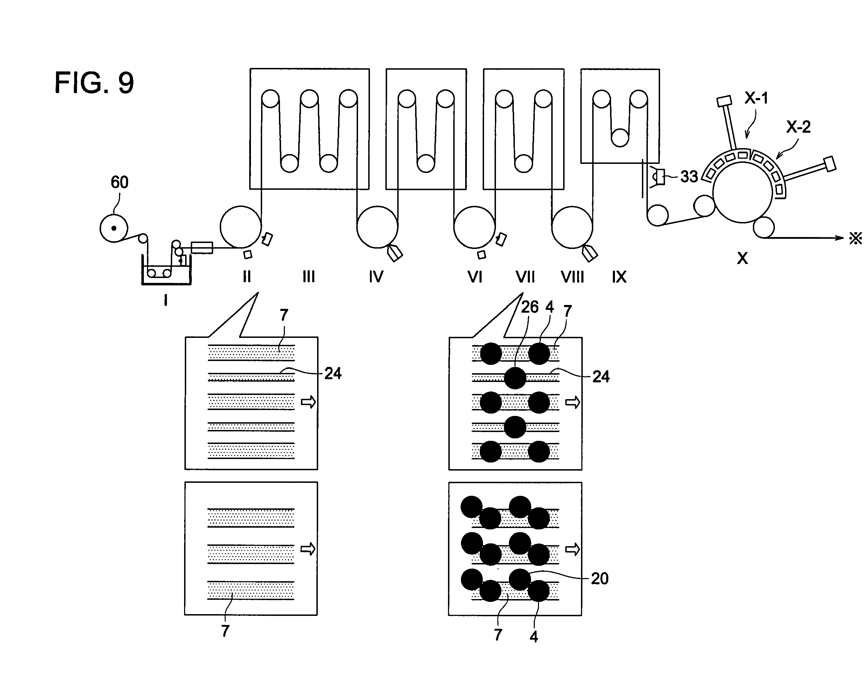

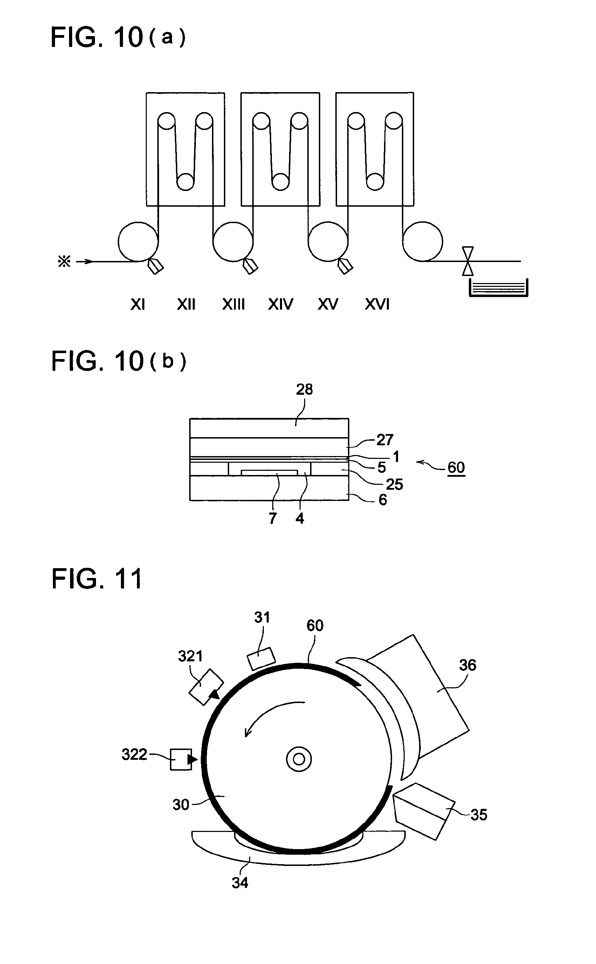

An example concerning a manufacturing method in the present invention which shows the manufacture of a substrate fixed on a rotating support is explained here by using Fig. 9 and Fig. 10.

The figures show a process of manufacturing a substrate fixed on a rotating support, conveying a film continuously coming from roll of a resin film (200 µm thick) 60 such as polyimide, polyethersulfone (PES) or polyethylene naphthalate (PEN).

A film surface is washed through washing process I by a known method, and adhering particles are removed at atmospheric pressure, for example, by conducting subbing treatment with an atmospheric pressure plasma method in advance. Next, as shown in the figure, gate busline 7 is linearly formed in process II by ejecting a copper particle dispersion liquid having a mean particle diameter of 20 nm from a piezo type ink jet head. At this time, a linearly arranged multi-nozzle head which is a film width wide is used as an ink jet head, and the film edge is detected by a sensor. The head is closely operated so as to form a line at a given location from the head position at the film edge, detecting out-of-line to the direction normal to the conveying direction. After a drying process at 100 °C and heat treatment at 150 °C in process III, the copper particles are heat-fused to form the pattern of gate busline 7 having a thickness of 500 nm. At this time, as shown in the figure, capacitor line 24 may be formed at the same time.

Next, SNOWTEX PSM (solid content of 20% by weight, manufactured by Nissan Chemical Industries, Ltd.) is coated on the surface having gate busline 7 in process IV and dried in process V, and insulating layer 25 which accepts a fluid electrode material having a thickness of 3 µm (referred to as a receptive layer) is formed.

0.05% by weight of a nonionic surfactant (polyoxyethylenealkyl ether) is added into an aqueous dispersion (Baytron P produced by Bayer Co., Ltd.) of a PEDOT (polyethylenedioxythiophene)-PSS (polystyrene sulfonic acid) complex to prepare an electrically conductive polymer solution. In process VI, this conductive polymer solution is ejected at the portion as shown in the figure according to a piezo type ink jet head, where the solution is allowed to permeate the receptive layer and dried in process VII to form gate electrode 4. At this time, simultaneously electrode for capacitor 26 is similarly formed on capacitor line 24 or an electrode for additional capacitor 20 is prepared on an adjacent busline.

Further in process VIII, after a coating liquid having the following composition is coated on the receptive layer to incorporate into the inside of the receptive layer, an excessive amount of the coating liquid is removed by either a blade or a roll. In process IX, the resulting layer is dried at 90 °C for one minute and hardened by being exposed 10 cm distant from the layer for 4 seconds, employing a 60 W/cm high pressure mercury lamp 33 in process IX.

| | |
|---|---|
| Dipentaerythritol hexacrylate monomer | 60 g |
| Dipentaerythritol hexacrylate dimmer | 20 g |
| Dipentaerythritol hexacrylate trimer or polymer higher than the trimer | 20 g |
| Diethoxybenzophenone (UV-initiator) | 2 g |
| Silicon-containing surfactant | 1 g |
| Methyl ethyl ketone | 75 g |
| Methyl propylene glycol | 75 g |

In process X, a 200 nm thick silicon oxide layer is formed as gate insulating layer 5 by an atmospheric pressure plasma method under the following conditions (X-1). In addition, a film temperature is set to 180 °C at this time.

| (Gas used) | |
|---|---|
| Inert gas: Helium | 98.25% by volume |
| Reactive gas: oxygen gas | 1.5% by volume |
| Reactive gas: tetraethoxysilane vapor (bubbled in a helium gas) | 0.25% by volume |
| (Discharge condition) | |
| Discharge output power: | 10 W/cm² |

The resulting silicon oxide layer was further subjected to atmospheric pressure plasma treatment employing trimethoxypropylsilane as a reactive gas to give a moisture repellent property (X-2).

Next, 50 nm thick semiconductor layer 1 is formed by coating a semiconductor material solution such as a □ conjugate polymer and so forth (process XI in Fig. 10 (a)).

A chloroform solution of a purified regioregular poly(3-hexylthiophene) (produced by Ardrich Co., Ltd.) is prepared, and the dissolved oxygen in the regioregular poly(3-hexylthiophene) chloroform solution is removed by bubbling with nitrogen to prepare a coating liquid. Subsequently, the semiconductor layer is coated in a nitrogen atmosphere and conveyed in drying process VII at a temperature of 60 °C for 3 minutes.

### <FORMING PROCESS OF LIGHT SENSITIVE LAYER; PROCESSES XIII & XIV>

The following composition is mixed and dispersed, and a light sensitive layer composition is prepared by adding a hardening agent such as a polyisocyanate compound and so forth. This is coated (process XIII) and dried (process XIV) to form light sensitive layer 27 having a thickness of 0.3 µm.

| | |
|---|---|
| Fe-Al system ferromagnetic metal powder | 100 parts |
| Carbon black | 30 parts |
| Novolak resin | 10 parts |
| Polyurethane | 15 parts |
| Methyl ethyl ketone | 300 parts |

### <FORMING PROCESS OF ELECTRODE MATERIAL-REPELLENT LAYER; PROCESSES XV & XVI>

The liquid in which the following composition is dissolved in Isopar E (isoparaffin type hydrocarbon, produced by Exxon Co. Ltd.) to dilute by a solid content of 10.3% by weight, is coated on light sensitive layer 27 (process XV) and dried (process XVI), and a silicone rubber layer having a thickness of 0.4 µm as electrode material-repellent layer 28 is formed.

**α, ω-Divinylpolydimethylsiloxane**

| | |
|---|---|
| (Molecular weight 60,000) | 100 parts |
| HMS-501 (Methylhydrogensiloxane-dimethylsiloxane copolymer having methyl groups on the chain ends, SiH number/molecular weight = 0.69 mol/g, produced by Chisso Co., Ltd.) | 7 parts |
| Vinyltris(methylethylketoxyimino)silane | 3 parts |
| SRX-212 (platinum catalyst, produced by Toray Dow Corning Silicone Co., Ltd.) | 5 parts |

Substrate 60 which is prepared as described above is cut into an appropriate size (process XVII). The cross-sectional structure is shown in Fig. 10(b).

### EXAMPLE

The present invention will be detailed employing the substrate prepared above, but the present invention is not limited thereto.

### Example 1

Substrate 60 which has been cut is placed on the apparatus which is schematically illustrated in Fig. 11.

Rotating support 30 in the present invention is a cylindrical drum having a diameter of 70 cm and a width of 150 cm whose rotating speed is from 0.1 to 1000 rpm.

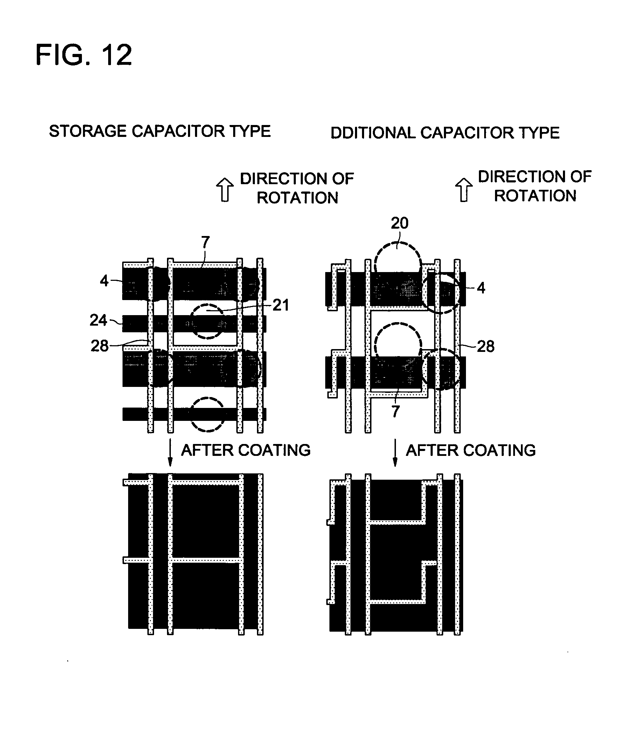

After a gate busline was set so as to be in the direction as shown in Fig. 12 to the direction of drum rotation by a clamp at sheet edge and vacuum drawing, the locations of gate busline 7 and gate electrode 4 were detected by reflection type location detection sensor 31, and the location of laser output described later was determined so as to be able to superpose the electrode pattern as shown in Fig. 12 (refer to Fig. 1 and Fig. 2).

By using semiconductor laser head 322 in which 500 lasers capable of 300 mW in peak power emitting light of a wavelength of 830 nm, there was given exposure, while rotating the drum at a rotating speed of 800 rpm, so that a pattern for electrode material-repellent layer 28 as shown in Fig. 12 was obtained by outer surface scanning of the cylinder after developing and an energy density of 300 mJ/cm² was obtained in a pattern of electrode and source busline 8, more specifically, except the area of electrode material-repellent layer 28.

After drum 30 was brought to a stop once, a silicone rubber layer of the light exposure area was removed at development mechanism 34 of the apparatus by brushing treatment while rotating the drum at a rotating speed of 0.5 rpm, and an exposed light sensitive layer was washed with methyl ethyl ketone (MEK) and removed. Further, it was washed with pure water and subsequently dried, conveying 90 °C dryer 36 at a rotating speed of 0.1 rpm.

Next, an aqueous dispersion (Baytron P produced by Bayer Co., Ltd.) of a PEDOT (polyethylenedioxythiophene)-PSS (polystyrene sulfonic acid) complex into which 0.01% by weight of a nonionic surfactant (polyoxyethylenealkyl ether) was added was supplied from coater head 35 and coated on the entire sheet surface while rotating drum 30 at a rotating speed of 1.0 rpm. This solution adhered to only the area other than the patterning area (region corresponding to electrode and source busline 8), because the patterning area of electrode material-repellent layer 28 repelled this solution (refer to Fig. 12). Further, an electrode made of an electrically conductive polymer was formed after it was dried while conveying 90 °C dryer 36 at a rotating speed of 0.1 rpm.

Next, a pattern of source busline 8 was formed by ejecting a copper particle dispersion liquid having a mean particle diameter of 20 nm, using piezo type ink jet head 321 which is linearly arranged drum 30 width wide. The pattern was formed at a rotating speed of 0.5 rpm, based on the location information which was detected. Further, the pattern of busline was heat-fused with 5 reciprocating rotations (0.1 rpm) of dryer 36 in which the radiant heat around the area of source busline 8 was set to 160 °C.

Finally, a MEK solution of polyvinylphenol was ejected onto source busline 8 from ink jet head 321 at a rotating speed of 0.5 rpm, and it was dried and sealed by letting dryer 36 be passed through at a rotating speed of 2 rpm.

### Example 2

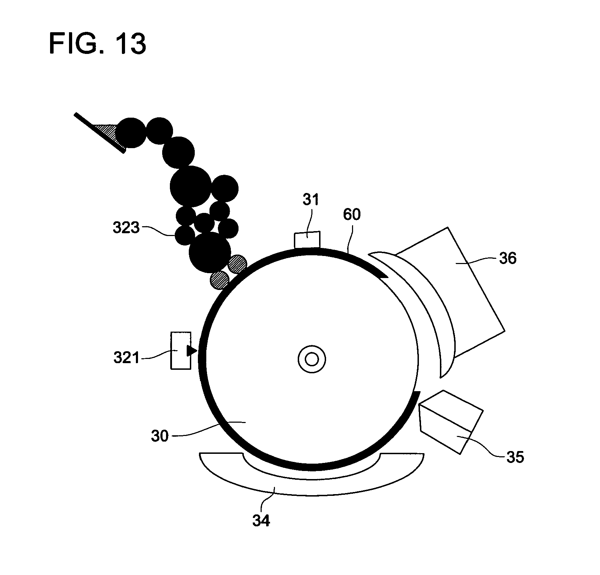

The same as EXAMPLE 1 was conducted, except that the apparatus was changed as schematically illustrated in Fig. 13, and the pattern of source busline was changed as follows. Incidentally, ink supply mechanism 323 used herein was designed to be of the structure in which ink was transported to a kneading roller from an ink reservoir through an ink source roller, a thin film process was conducted by the kneading roller, and the ink was transported onto a substrate from a transfer roller.

The silver paste available on the market was transferred onto the entire surface of a substrate from ink supply mechanism 323. This paste adhered to only the area other than the patterning area (region corresponding to electrode and source busline 8), because the patterning area of electrode material-repellent layer 28 repelled this paste. The pattern of paste was heat-fused with 5 reciprocating rotations (0.1 rpm) of dryer 36 in which the radiant heat around this paste area was set to 160 °C.

Finally, a MEK solution of polyvinylphenol was ejected onto source busline 8 from ink jet head 321 at a rotating speed of 0.5 rpm, and it was dried and sealed by letting dryer 36 be passed through at a rotating speed of 2 rpm.

### Example 3

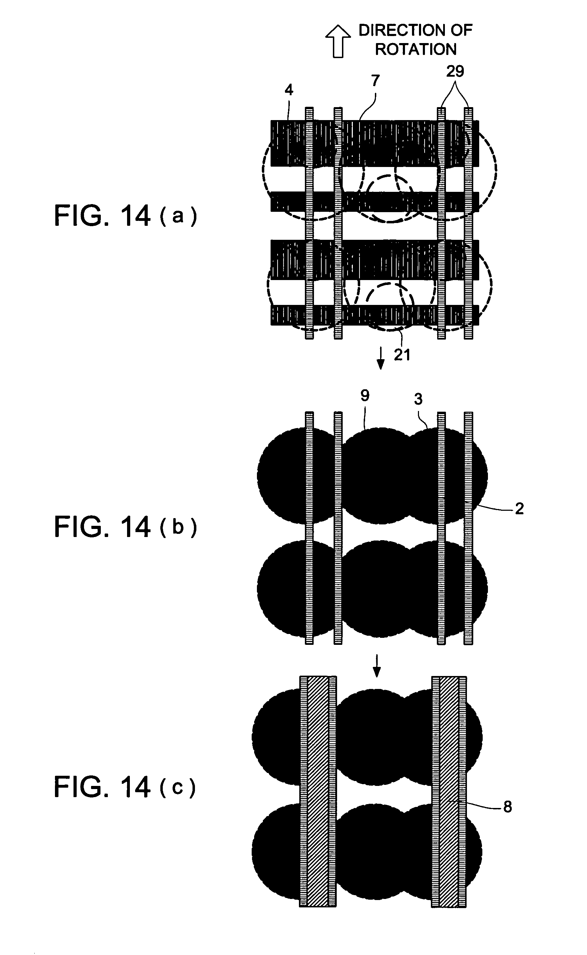

The substrate (having neither light sensitive layer nor electrode material-repellent layer on an organic semiconductor layer) which was cut after completing the foregoing process VII was used, and the apparatus as shown in Fig. 11 in which laser head 322 was changed to a known static suction type ink jet head was used. Incidentally, Fig. 14 is the figure for explaining a TFT formation process.

Repellent region 29 necessary for forming a semiconductor layer and a busline was linearly formed by continuous spray with the static suction type ink jet head while rotating drum 30 at a rotating speed of 50 rpm. Incidentally, a fluid material, wherein organosiloxane and its catalytic hardner are mixed, was used as an ejecting material for forming repellent region 29. Dryer 36 was set to 120 °C after a patterning process, and repellent region 29 was hardened, rotating the drum for 3 minutes at a rotating speed of 1 rpm (Fig. 14(a)).

An aqueous dispersion (Baytron P produced by Bayer Co., Ltd.) of a PEDOT (polyethylenedioxythiophene)-PSS (polystyrene sulfonic acid) complex into which 0.05% by weight of a nonionic surfactant (polyoxyethylenealkyl ether) was added was ejected in a patterning area shown in Fig. 14(a) with dotted lines. The drum rotation speed when ejecting was set to 3 rpm, and adjustment was made so as to superpose the pattern with a dotted line to the location shown in Fig. 14(a) at preset timing. This solution adhered to only the region other than repellent region 29 corresponding to source electrode 2, drain electrode 3 and pixel electrode 9, because repellent region 28 repelled this solution (Fig. 14(b)). Without changing the drum rotation speed, a drying process was conducted by letting dryer 36 be passed through for 3 minutes.

Next, a pattern of source busline 8 was formed by ejecting a copper particle dispersion liquid having a mean particle diameter of 20 nm from static suction type ink jet head 324. The region between repellent regions 29 was continuously sprayed, based on the location information which was detected, and the pattern was formed at a rotating speed of 0.5 rpm. Further, the pattern of busline was heat-fused with 5 reciprocating rotations (0.1 rpm) of dryer 36 in which the radiant heat around the area of source busline 8 was set to 160 °C (Fig. 14(c)).

Finally, a MEK solution of polyvinylphenol was ejected onto source busline 8 from ink jet head 321 at a rotating speed of 0.5 rpm, and it was dried and sealed by letting dryer 36 be passed through at a rotating speed of 2 rpm.

### Example 4

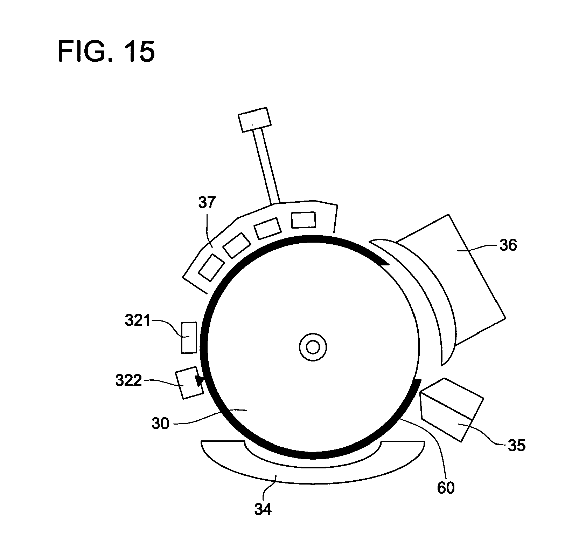

After a 150 µm thick polyimide film on which aluminum was evaporated 200 µm thick was cut, it was set on drum 30 in the apparatus by a clamp at sheet edge and vacuum drawing as schematically illustrated in Fig. 15. A photoresist material having the following composition was coated on the aluminum-evaporated surface by coater head 35 shown in the figure.

| | |
|---|---|
| Dye A | 7 parts |
| Novolak resin | 90 parts |

(Condensation product of phenol, m-, p-mixed cresol, and formaldehyde, Mw = 4,000, phenol: m-cresol: p-cresol = 5:57:38 by mole)

| | |
|---|---|
| Crystal violet | 3 parts |
| propylene glycol monomethyl ether | 1000 parts |

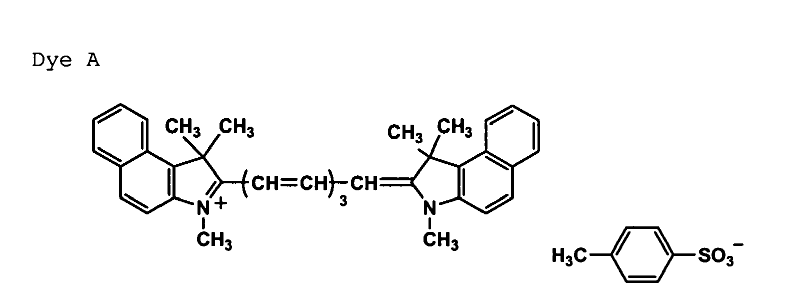

After coating, the photoresist material was dried by letting dryer 36 be passed through at a rotating speed of 1 rpm for 5 minutes.

Using semiconductor laser head 322 in which 500 lasers capable of 300 mW in peak power emitting light of a wavelength of 830 nm were linearly arranged, the area except the patterning area of a gate electrode and a gate busline was exposed while rotating the drum at a rotating speed of 800 rpm so as to be at an energy density of 300 mJ/cm² by outer surface scanning of the cylinder.

After drum 30 was brought to a stop once, a photoresist material of the light exposure area was removed at development mechanism 34 of the apparatus by an alkali developer while rotating the drum at a rotating speed of 0.5 rpm, and was sufficiently washed with water. Next, development mechanism 34 was changed to etching mechanism, and after an exposed aluminum-evaporated layer was removed by an etching solution, a remaining photoresist layer was removed by MEK while rotating the drum at a rotating speed of 0.5 rpm, and a washing process was further conducted with pure water, a drying process was conducted, conveying 90 °C dryer 36 at a rotating speed of 0.1 rpm.

A 200 nm thick silicon oxide layer was formed as a gate insulating layer by using atmospheric pressure plasma mechanism 37. A surface temperature of drum 30 was set to 200 °C at this time, and atmospheric pressure plasma treatment was conducted with reciprocating rotation (0.1 rpm) under the following condition.

| (Gas used) | |
|---|---|
| Inert gas: Helium | 98.25% by volume |
| Reactive gas: oxygen gas | 1.5% by volume |
| Reactive gas: tetraethoxysilane vapor (bubbled in a helium gas) | 0.25% by volume |

| (Discharge condition) | |
|---|---|
| Discharge output power: | 10 W/cm² |

The resulting silicon oxide layer was further subjected to atmospheric pressure plasma treatment employing only trimethoxypropylsilane as a reactive gas to give a moisture repellent property while rotating once at a rotating speed of 1 rpm.

Next, a pattern of a semiconductor layer was formed by ejecting a chloroform solution having a compound shown below onto a portion of the gate electrode by piezo type ink jet head 321 which was linearly arranged the drum width wide while rotating the drum at a rotating speed of 0.5 rpm. Further, a drum temperature was set to 200 °C, the heat treatment was conducted for 5 minutes, and an organic semiconductor layer of a 50 nm thick pentacene film was formed.

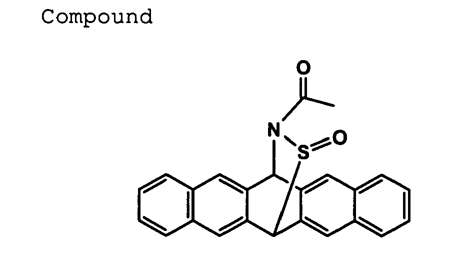

Next, the pattern for a source electrode and a drain electrode was formed by ejecting a gold particle dispersion liquid having a mean particle diameter of 20 nm, using ink jet head 321 while rotating the drum at a rotating speed of 0.5 rpm, and then the pattern for a pixel electrode and a source busline was formed to connect the source electrode with the drain electrode by ejecting a copper particle dispersion liquid having a mean particle diameter of 20 nm. Further, the pattern for each of electrodes and the source busline was heat-fused with 5 reciprocating rotations (0.1 rpm) of dryer 36 in which the radiant heat was set to 230 °C.

Finally, a MEK solution of polyvinylphenol was ejected onto the source busline from ink jet head 321 at a rotating speed of 0.5 rpm, and it was dried and sealed by letting dryer 36 be passed through at a rotating speed of 2 rpm.

### Possibility of industrial use

According to the present invention, a TFT sheet in reduced fluctuation of performance of each TFT formed on a sheet can be obtained since the location accuracy is improved by being able to effectively manufacture a TFT sheet with ease. The location accuracy between elements which is necessary for each process can also be improved without aligning for each process since a plurality of processes are conducted on the rotating support on which a substrate is fixed.

## Claims

1. A manufacturing method of a thin-film transistor (TFT) sheet having elements including a source electrode, a drain electrode, a gate electrode, a gate insulating layer and a semiconductor layer on a substrate comprising the step of conducting two or more element-forming processes while rotating a rotating support, after the substrate is fixed on the rotating support.

2. The manufacturing method of the TFT sheet of Claim 1,
wherein the two processes or more which are conducted while rotating the rotating support, include any one of formation processes of the source electrode, the drain electrode and the source busline.

3. The manufacturing method of the TFT sheet of Claim 1,
wherein a process through which elements are formed while rotating the rotating support includes either an ink jet method or a laser irradiation method.

4. The manufacturing method of the TFT sheet of Claims 1,
wherein the process through which elements are formed while rotating the rotating support includes a coating process.

5. The manufacturing method of the TFT sheet of Claims 1,
wherein the process through which elements are formed while rotating the rotating support includes either a drying process or a heat treatment process.

6. The manufacturing method of the TFT sheet of Claims 1,
wherein the process through which elements are formed while rotating the rotating support includes an atmospheric pressure plasma process.

7. The manufacturing method of the TFT sheet of Claims 1,
wherein the process through which elements are formed while rotating the rotating support includes a process for forming a light sensitive layer which is exposed before developing.

8. The manufacturing method of the TFT sheet of Claims 1,
wherein the process through which elements are formed while rotating the rotating support includes either a developing process or a washing process.

9. The manufacturing method of the TFT sheet of Claims 1,
wherein a rotating condition of the rotating support is changed at least one time in two different processes or more through which elements are formed while rotating the rotating support.

10. The manufacturing method of the TFT sheet of Claims 1,
wherein after a substrate, on which at least one element selected from the foregoing elements is formed in advance, is fixed on the rotating support, a location of the element formed is detected, and another element is formed, based on the location information, at the location of sequence by reading out information of the location and the shape for at least one different element which is additionally formed while rotating the rotating support.

11. The TFT sheet manufactured by the method of Claims 1.
